(19) Europäisches Patentamt
European Patent Office
Office européen des brevets

(11) **EP 4 586 503 A1**

(12) **EUROPEAN PATENT APPLICATION**

(43) Date of publication:
**16.07.2025   Bulletin 2025/29**

(21) Application number: **25150707.5**

(22) Date of filing: **08.01.2025**

(51) International Patent Classification (IPC):
**H03M 13/11** (2006.01)   **H03M 13/00** (2006.01)
**H04L 1/00** (2006.01)

(52) Cooperative Patent Classification (CPC):
**H03M 13/116; H03M 13/1102; H03M 13/618;**
**H03M 13/6356; H03M 13/6362; H03M 13/6516;**
**H03M 13/6527; H04L 1/0041**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **11.01.2024   US 202463619958 P**
**29.04.2024   US 202418649291**

(71) Applicant: **Avago Technologies International**
**Sales**
**Pte. Limited**
**Singapore 768923 (SG)**

(72) Inventors:
• **Blanksby, Andrew**
 **Irvine, 92618 (US)**
• **Pulikkoonattu, Rethnakaran**
 **Irvine, 92618 (US)**
• **Zheng, Jun**
 **Irvine, 92618 (US)**
• **Porat, Ron**
 **Irvine, 92618 (US)**
• **Erceg, Vinko**
 **Irvine, 92618 (US)**

(74) Representative: **Dilg, Haeusler, Schindelmann**
**Patentanwaltsgesellschaft mbH**
**Leonrodstraße 58**
**80636 München (DE)**

(54) **SYSTEMS AND METHODS FOR LOW DENSITY PARITY CHECK (LDPC) ENCODING AND RATE MATCHING**

(57) A system (105) may include a transmitter (120) and one or more processors (2010). The one or more processors (2010) may be configured to identify a number of additional symbols to be added to existing symbols corresponding to payload data to be encoded. The one or more processors (2010) may be configured to calculate, based on a length of the payload data and the number of additional symbols, a number of available bits for error correction. The one or more processors (2010) may be configured to encode, via an low-density parity-check (LDPC) encoder (130), the payload data using an LDPC code to generate a codeword having a number of parity bits corresponding to the available bits. The one or more processors (2010) may be configured to transmit, via the transmitter (120), the encoded data.

FIG. 3

**Description**

**Cross-Reference to Related Applications**

This application claims the benefit of priority to each of U.S. Provisional Patent Application No. 63/619,958 filed on January 11, 2024, which is incorporated herein by reference in its entirety for all purposes.

**Field of the Disclosure**

This disclosure generally relates to systems and methods for improving an encoding process and/or a rate matching process of a communications system using a low-density parity-check (LDPC) code.

**Background**

Error correcting codes enable information data to be exchanged between a transmitter communication system and a receiver communication system in a reliable manner. A transmitter communication system encodes the information data to obtain a codeword. The codeword is encoded information data. The transmitter communication system transmits the codeword to the receiver communication system. Due to noise in the communication channel, the transmission received by the receiver communication system may not be identical to the transmitted codeword. Encoding information data allows a receiver communication system with a proper decoding process to recover the information data from the received transmission despite such noise. For example, the transmitter communication system transmits parity bits to the receiver communication system. The parity bits allow the receiver communication system to verify whether the received transmission is a valid codeword and to correct errors in the transmission if the received transmission is not a valid codeword. In one approach, generating parity bits involves a complex process.

**Brief Description of the Drawings**

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1 is a diagram depicting an example communication environment with communication systems, according to one or more embodiments.
FIG. 2 is a schematic block diagram of a computing system, according to an embodiment.
FIG. 3 is a diagram depicting an example rate matching system, according to one or more embodiments.
FIG. 4A, FIG. 4B, and FIG. 4C are diagrams depicting example rate matching schemes including shortening, puncturing, and repeating, respectively, according to one or more embodiments.
FIG. 5A, FIG. 5B, FIG. 5C, and FIG. 5D are diagrams depicting example simulation results of a rate matching system, according to one or more embodiments.
FIG. 6A, FIG. 6B, FIG. 6C, and FIG. 6D are diagrams depicting example simulation results of a rate matching system, according to one or more embodiments.
FIG. 7A, FIG. 7B, FIG. 7C, and FIG. 7D are diagrams depicting example simulation results of a rate matching system, according to one or more embodiments.
FIG. 8 shows diagrams depicting example simulation results with which to determine a minimum number of additional (bonus) symbols as a parameter of a rate matching system, according to one or more embodiments.
FIG. 9 is a flow diagram showing a process for encoding data using a rate matching system, in accordance with an embodiment.
FIG. 10 is a flow diagram showing a process for encoding data using a rate matching system, in accordance with an embodiment.

The details of various embodiments of the methods and systems are set forth in the accompanying drawings and the description below.

**Detailed Description**

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

In one aspect, a parity check matrix defines a set of equations that are satisfied by any valid codeword. The parity check matrix may be used for encoding low density parity check ("LDPC") codes, described by Richardson and Urbanke in IEEE Transactions on Information Theory, Vol. 47, No. 2 (February 2001). Generally, many wireless and wireline communication systems use LDPC as a forward error correction coding scheme.

LDPC Physical Layer Protocol Data Unit (PPDU) encoding processes are defined in wireless communication standards (e.g., the IEEE 802.11n) to map an integer number of data bytes to an integer number of orthogonal frequency-division multiplexing (OFDM) symbols, and to an integer number of LDPC codewords. In error correction codes, e.g., LDPC codes, rate matching technique may be applied to adapt the code rate to match specific communication requirements. For example, the IEEE 802.11n standard defines, as rate matching techniques, shortening, puncturing, and/or repeating pattern for each codeword. An explicit payload length signaling defined in the standards (e.g., IEEE 802.11n) was replaced with an implicit scheme in the IEEE 802.11ac, for example, rounding payload up to the next pre-forward error correction (FEC) symbol boundary with pre-FEC padding. Such implicit scheme of 802.11ac was extended in the IEEE 802.11ax and the IEEE 802.11be with a-factor "short symbol padding." The a-factor values refer to packet extension (PE) durations for different pre-FEC padding boundaries. For example, an a-factor value of 1 indicates 4μs or ¼ long symbol, while an a-factor value of 4 indicates 16μs or 1 long symbol. A short symbol refers to a symbol created by reducing the number of subcarriers within a symbol (e.g., an OFDM symbol) which results in a shorter duration for the symbol. For multi-user (MU)-MIMO (multiple input multiple output) and orthogonal frequency-division multiple access (OFDMA), a two pass calculation can be used across all users to normalize the payload length to a common transmission length.

LDPC rate matching schemes may have a problem that sensitivity (e.g., receiver sensitivity or sensitivity in the receiver) is not a continuous function (e.g., a function of payload length) due to large discontinuities in the number of punctured bits per codeword. Moreover, the pre-FEC padding introduced in the IEEE 802.11ac may result in unnecessary codewords being decoded at the receiver. The receiver sensitivity refers to a minimum required power of a signal entering a receiver terminal, such that the Rx (receive) circuitry can demodulate and recover the information successfully. Successful recovery may be determined based on one or more metrics such as a minimum packet error rate or a throughput.

A PPDU encoding process may define a payload length $N_{pld}$ and the number of available bits $N_{avbits}$ as follows:

$$N_{pld} = length \times 8 + 16 \qquad \ldots\ldots\ldots\ldots \text{(Equation 1)},$$

$$N_{avbits} = N_{CBPS} \times (1 + U_{STBC}) \times ceil\left(\frac{N_{pld}}{N_{CBPS} \times R \times (1 + U_{STBC})}\right) \ldots\ldots\ldots\ldots \text{(Equation 2)},$$

where *length* is the number of octets in the payload; $N_{CBPS}$ is the number of coded bits per (OFDM) symbol; $U_{STBC}$ is 1 if space-time block coding (STBC) is used and is 0 otherwise; and R is a code rate. The available bits $N_{avbits}$ refers to the number of bits in a minimum number of modulation symbols in which the payload may fit.

An LDPC codeword size and the number of codewords may be calculated based on the payload length $N_{pld}$, the number of available bits $N_{avbits}$, and/or the code rate R, using Table 1 below.

Table 1. Calculation of the LDPC codeword size and the number of codewords

| Range of $N_{avbits}$ | Number of codewords $N_{CW}$ | Codeword length $L_{LDPC}$ |
|---|---|---|
| $N_{avbits} \leq 648$ | 1 | 1296 if $N_{avbits} \geq N_{pld} + 912(1 - R)$ else 648 |
| $648 < N_{avbits} \leq 1296$ | 1 | 1944 if $N_{avbits} \geq N_{pld} + 1464(1 - R)$ else 1296 |
| $1296 < N_{avbits} \leq 1944$ | 1 | 1944 |
| $1944 < N_{avbits} \leq 2592$ | 2 | 1944 if $N_{avbits} \geq N_{pld} + 2916(1 - R)$ else 1296 |
| $2592 < N_{avbits}$ | $\left\lceil \dfrac{N_{pld}}{1944 \cdot R} \right\rceil$ | 1944 |

In one aspect, Ultra High Reliability (UHR) is a new study group within the IEEE 802.11 working group. Its purpose is to investigate PHY (physical layer) and MAC (medium access control) technologies that can enhance the reliability of WLAN (wireless local area network) connectivity. Companies collaborating in the UHR have proposed many rate matching schemes (e.g., increasing the granularity of the a-factor from 4 to 8 or more segments per OFDM symbol). There may be lack of rate matching solutions that can provide sensitivity as a continuous function (e.g., a function of payload length) and/or expand rate matching schemes to include 2x length (3888-b) LDPC codes if the 3888-b LDPC codes are adopted in UHR.

To solve these problems, according to certain aspects, embodiments in the present disclosure relate to a technique to provide/support/utilize one or more "extra LDPC symbols" of parity bits to reduce the number of punctured bits. In some implementations, a rate matching system/method (referred to as "system," "method," or "system/method") can increase the number of available bits $N_{avbits}$ for LDPC encoded data by adding extra/additional/bonus symbols (e.g., the number of bonus symbols $N_{bonus}$) into the calculation of the number of available bits as follows:

$$N_{avbits} = N_{CBPS} \times (1 + U_{STBC}) \times \left( ceil \left( \frac{N_{pld}}{N_{CBPS} \times R \times (1 + U_{STBC})} \right) + N_{bonus} \right)$$

….. (Equation 3).

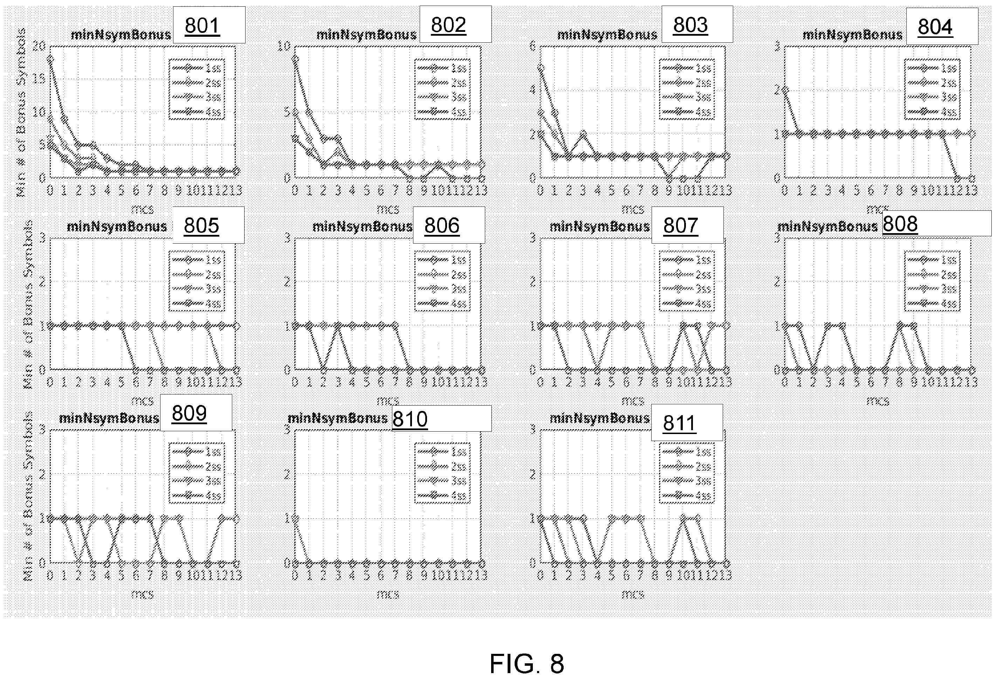

In some implementations, $U_{STBC}$ may be set to zero (0). In some implementations, $N_{bonus}$ is an integer such that $0 < N_{bonus} < 20$. In some implementations, the system can experimentally (e.g., using simulations) determine $N_{bonus}$ that is a minimum number of bonus symbols that can reduce the number of punctured bits to a threshold. In some implementations, the system can experimentally determine $N_{bonus}$ that is a minimum number of bonus symbols that can reduce the rate (or %) of parity puncture (or "parity puncture rate" or "parity puncture %") to a threshold. The parity puncture rate or parity puncture % may refer to a percentage of punctured bits out of the total parity bits. For example, FIG. 8 shows simulation results based on which to determine a minimum value of $N_{bonus}$ that can reduce the parity puncture rate to 8%.

In some implementations, the system can determine/calculate/obtain/identify the number of bonus symbols $N_{bonus}$ a priori. In some implementations, the system can determine/obtain/identify $N_{bonus}$ by referring to a standard (e.g., as part of the UHR specification) as a function of bandwidth (BW), the number of spatial streams (NSS), and/or modulation and coding scheme (MCS). For example, the system can retrieve $N_{bonus}$ from a look-up table (LUT) using at least one of BW, NSS, or MCS.

In one aspect, for smaller payload sizes, as $N_{avbits}$ is increased by adding bonus symbols, larger codeword sizes may be selected, which may lead to excessive puncturing per codeword. To address this problem, the system can allow multiple smaller codeword sizes to be used for small payload sizes which can reduce the parity puncture % per codeword. In some implementations, given $N_{avbits}$, $N_{pld}$, and R, the system can calculate/determine/compute the number of codewords $N_{CW}$ and LDPC codeword length $L_{LDPC}$ using Table 2 below.

Tale 2. Calculation (or determination) of the number of codewords and the LDPC codeword size.

| Range of $N_{avbits}$ | Number of codewords $N_{CW}$ | Codeword length $L_{LDPC}$ |
|---|---|---|
| $N_{avbits} \leq K \cdot 648$ | $\left\lceil \dfrac{N_{pld}}{648 \cdot R} \right\rceil$ | 648 |
| $K \cdot 648 < N_{avbits} \leq M \cdot 1296$ | $\left\lceil \dfrac{N_{pld}}{1296 \cdot R} \right\rceil$ | 1296 |
| $M \cdot 1296 < N_{avbits}$ | $\left\lceil \dfrac{N_{pld}}{1944 \cdot R} \right\rceil$ | 1944 |

In Table 2, K, M are adjustable parameters (integers) that can be adjusted/set by the system. In some implementations, the system may set K to an integer greater than 2, and/or set M to an integer greater than 2. In some implementations, the system can determine/obtain K and/or M (e.g., as small integers) from a standard (e.g., UHR specification or a look-up table).

In some implementations, the system can calculate (based on at least one of $N_{avbits}$, $N_{pld}$, R, $N_{CW}$, or $L_{LDPC}$, as calculated above) the number of shortened bits $N_{shrt}$, the number of punctured bits $N_{punc}$, and/or the number of repeated bits $N_{rep}$ using the equations below.

$$N_{shrt} = max\big(0, (N_{CW} \times L_{LDPC} \times R) - N_{pld}\big) \dots\dots\dots\dots \text{(Equation 4)},$$

where shortened bits may be evenly distributed over all codewords with the first $rem(N_{shrt}, N_{CW})$ codewords shortened by 1 more bit. Here, r = rem( a, b ) returns the remainder after division of a by b, where a is the dividend and b is the divisor.

$$N_{punc} = max(0, (N_{CW} \times L_{LDPC}) - N_{avbits} - N_{shrt}) \dots\dots\dots\dots \text{(Equation 5)}.$$

In some implementations, the system may determine (based on at least one of $R$, $N_{CW}$, or $L_{LDPC}$, $N_{shrt}$, or $N_{punc}$) whether to send an "extra symbol" of parity bits. For example, the system can send an "extra symbol" of parity bits if ($N_{punc} >$ 0.1 $\times$ $N_{CW} \times L_{LDPC}(1 - R)$; AND $N_{shrt} < 1.2 \times N_{punc} \times \frac{R}{1-R}$) OR ($N_{punc} > 0.3 \times N_{CW} \times L_{LDPC}(1 - R)$). The extra symbol may have a value of 0 or 1, which indicates whether a puncture condition is invoked. The puncture condition refers to a condition in which an additional short symbol of parity bits can be used.

$$N_{rep} = max\big(0, N_{avbits} - (N_{CW} \times L_{LDPC}) - N_{pld}\big) \dots\dots\dots\dots \text{(Equation 6)},$$

where repeated bits are evenly distributed over all codewords with the first $rem(N_{rep}, N_{CW})$ codewords having 1 repeated bit more.

In some implementations, the system can reduce the transmission length by using $N_{bonus}$ "short symbols" rather than full symbols with some increase in complexity. For example the system can calculate/compute/obtain/determine the number of available bits $N_{avbits}$ using the equation below.

$$N_{avbits} = N_{CBPS} \times (1 + U_{STBC}) \times \left( ceil \left( \frac{N_{pld}}{N_{CBPS} \times R \times (1 + U_{STBC})} \right) \right) + N_{CBPS\_Short} \times (1 +$$

$$U_{STBC}) \times N_{Bonus\_Short} \dots\dots\dots\dots \text{(Equation 7)},$$

where $N_{CBPS\_Short}$ is the number of coded bits per (OFDM) short symbol, and $N_{Bonus\_Short}$ is the number of bonus short symbols.

In some implementations, a rate matching system may include a rate matching (RM) controller, a bit repeater, an LDPC encoder, a bit shortener, and/or a parity puncturer. In some implementations, the rate matching system may be included in an encoder or a baseband circuitry. In some implementations, the rate matching system may be implemented as one or more processors, application specific integrated circuit (ASIC), field programmable gate array (FPGA), or any combination of them. The RM controller may receive/obtain/identify/calculate at least one of $N_{bonus}$, K, or M, and calculate/compute/obtain at least one of the number of available bits $N_{avbits}$, the number of codewords $N_{CW}$, or LDPC codeword length $L_{LDPC}$ (e.g., using Equation 3 and Table 2). The RM controller then may provide the calculated $N_{avbits}$, $N_{CW}$, or $L_{LDPC}$ (as encoder parameters) to the LDPC encoder so that the LDPC encoder can encode data according to the encoder parameters.

In some implementations, the RM controller can control at least one of the bit repeater, the parity puncturer, or the bit shortener, based on $N_{avbits}$, $N_{CW}$, and/or $L_{LDPC}$ as calculated above. For example, the RM controller can control the bit repeater using a control signal based on a value of $N_{rep}$ calculated using Equation 6. The RM controller can control the bit shortener using a control signal based on a value of $N_{shrt}$ calculated using Equation 4. The RM controller can control the parity puncturer using a control signal based on a value of $N_{punc}$ calculated using Equation 5.

In some implementations, the bit shortener may zero pad data bits (e.g., zero padded bits or "shortened bits") to match the number of systematic bits per codeword before encoding, and discard the shortened bits after encoding. In this manner, the bit shortener can reduce the effective code rate and improve a coding gain. In some implementations, the parity puncturer may discard some parity bits (e.g., "punctured bits") after encoding. In this manner, the parity puncturer can increase the effective code rate and degrade a coding gain. In some implementations, the bit repeater may copy some bits (e.g., "repeated bits") from the start of the codeword. In this manner, the bit repeater can improve signal-to-noise ratio (SNR).

In some implementations, a system may include a transmitter and one or more processors. The one or more processors may be configured to identify a number of additional symbols to be added to existing symbols corresponding to payload data to be encoded. The one or more processors may be configured to calculate, based on a length of the payload data and the number of additional symbols, a number of available bits for error correction. The one or more processors may be configured to encode, via an low-density parity-check (LDPC) encoder, the payload data using an LDPC code to generate a codeword having a number of parity bits corresponding to the available bits. The one or more processors may be configured to transmit, via the transmitter, the encoded data.

In some implementations, to encode the payload data, the one or more processors may be configured to receive a plurality of information bits that contain the payload data and a set of bits having the calculated number of available bits. The one or more processors may be configured to encode the plurality of information bits to generate the codeword.

In some implementations, to identify the number of additional symbols to be added to the existing symbols, the one or more processors may be configured to determine a number of shortened bits. The one or more processors may be configured to determine, based on the number of shortened bits, a number of punctured bits and a percentage of punctured bits. To identify the number of additional symbols to be added to the existing symbols, the one or more processors may be configured to identify the number of additional symbols that reduces the percentage of punctured bits to a threshold percentage. The identified number of additional symbols may be a minimum number of additional bits that reduces the percentage of punctured bits to the threshold percentage.

In some implementations, to identify the number of additional symbols to be added to the existing symbols, the one or more processors may be configured to determine the number of additional symbols based on at least one of bandwidth, a number of spatial streams, or a modulation and coding scheme.

Embodiments in the present disclosure have at least the following advantages and benefits.

First, embodiments in the present disclosure can provide useful techniques for simply updating the PPDU encoding equations (e.g., adding $N_{bonus}$ to Equation 3), thereby reducing the number of punctured bits per LDPC codeword and minimizing discontinuities in the receiver sensitivity as a function of payload length.

Second, embodiments in the present disclosure can provide useful techniques for reducing the parity puncture rate and improve the receiver sensitivity, for short payloads. For example, the system can further reduce the parity puncture rate and improve the receive sensitivity using more LDPC codewords of shorter length (e.g., according to Table 2) in place of fewer LDPC codewords of longer length which may lead to higher parity puncturing percentage.

Third, embodiments in the present disclosure can provide useful techniques for rate matching without signaling requirement or changes to short symbol padding.

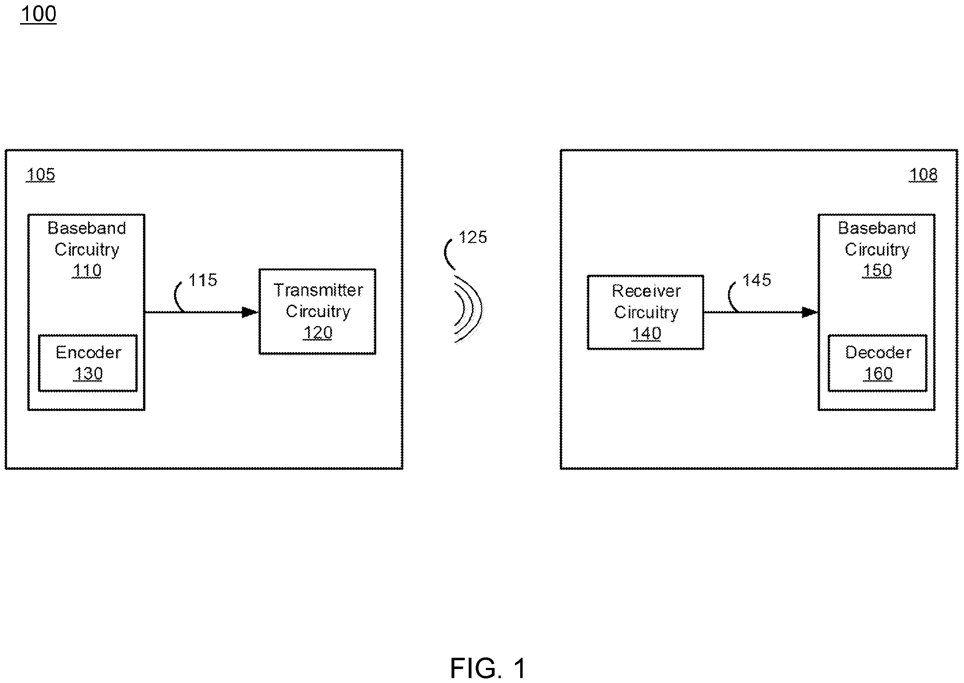

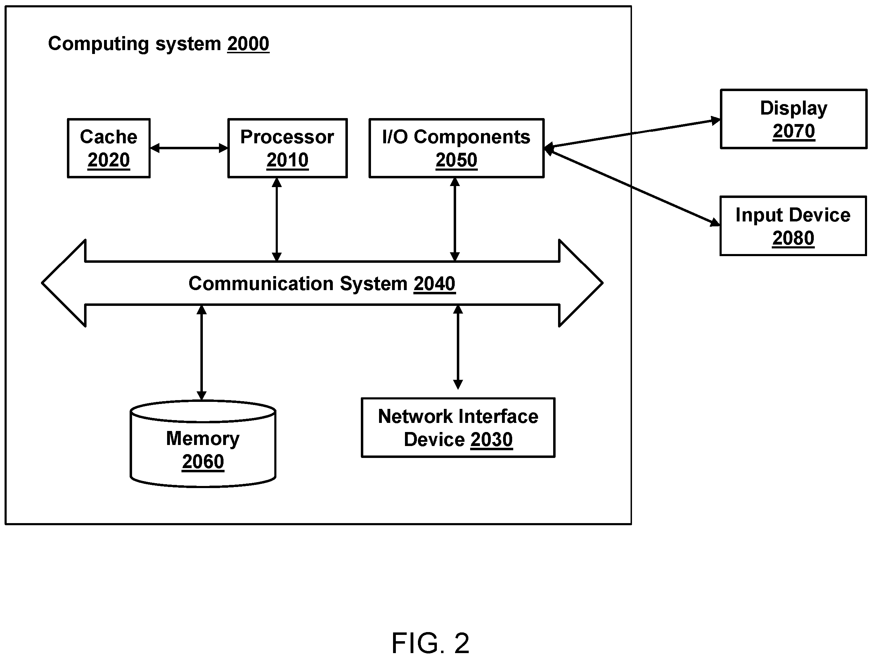

Referring to FIG. 1, illustrated is a diagram depicting an example communication environment 100 including communication systems (or communication apparatuses) 105, 108, according to one or more embodiments. In one embodiment, the communication system 105 includes a baseband circuitry 110 and a transmitter circuitry 120, and the communication system 108 includes a baseband circuitry 150 and a receiver circuitry 140. In one aspect, the communication system 105 is considered a transmitter communication system, and the communication system 108 is considered a receiver communication system. These components operate together to exchange data (e.g., messages or frames) through a wireless medium. These components are embodied as application specific integrated circuit (ASIC), field programmable gate array (FPGA), or any combination of these, in one or more embodiments. In some embodiments, the communication systems 105, 108 include more, fewer, or different components than shown in FIG. 1. For example, each of the communication systems 105, 108 includes transceiver circuitry to allow bi-directional communication between the communication systems 105, 108 or with other communication systems. In some embodiments, each of the communication systems 105, 108 may have configuration similar to that of a computing system 2000 as shown in FIG. 2.

The baseband circuitry 110 of the communication system 105 is a circuitry that generates the baseband data 115 for transmission. The baseband data 115 includes information data (e.g., signal(s)) at a baseband frequency for transmission. In one approach, the baseband circuitry 110 includes an encoder 130 that encodes the data, and generates or outputs parity bits. In one aspect, the baseband circuitry 110 (or encoder 130) obtains a generator matrix or a parity check matrix, or uses a previously produced generator matrix or a previously produced parity check matrix, and encodes the information data by applying the information data to the generator matrix or the parity check matrix to obtain a codeword. In some embodiments, the baseband circuitry 110 stores one or more generator matrices or one or more parity check matrices that conform to any IEEE 802.11 standard for WLAN communication. The baseband circuitry 110 retrieves the stored generator matrix or the stored parity check matrix in response to detecting information data to be transmitted, or in response to receiving an instruction to encode the information data. In one approach, the baseband circuitry 110 generates the parity bits according to a portion of the generator matrix or using the parity check matrix, and appends the parity bits to the information bits to form a codeword. The baseband circuitry 110 generates the baseband data 115 including the codeword for the communication system 108, and provides the baseband data 115 to the transmitter circuitry 120.

The transmitter circuitry 120 of the communication system 105 includes or corresponds to a circuitry that receives the baseband data 115 from the baseband circuitry 110 and transmits a wireless signal 125 according to the baseband data 115. In one configuration, the transmitter circuitry 120 is coupled between the baseband circuitry 110 and an antenna (not shown). In this configuration, the transmitter circuitry 120 up-converts the baseband data 115 from the baseband circuitry 110 onto a carrier signal to generate the wireless signal 125 at an RF frequency (e.g., 10 MHz to 60 GHz), and transmits the wireless signal 125 through the antenna.

The receiver circuitry 140 of the communication system 108 is a circuitry that receives the wireless signal 125 from the communication system 105 and obtains baseband data 145 from the received wireless signal 125. In one configuration, the receiver circuitry 140 is coupled between the baseband circuitry 150 and an antenna (not shown). In this configuration, the receiver circuitry 140 receives the wireless signal 125 though an antenna, and down-converts the wireless signal 125 at an RF frequency according to a carrier signal to obtain the baseband data 145 from the wireless signal 125. The receiver circuitry 140 then provides the baseband data 145 to the baseband circuitry 150.

The baseband circuitry 150 of the communication system 108 includes or corresponds to a circuitry that receives the baseband data 145 from the receiver circuitry 140 and obtains information data from the received baseband data 145. In one embodiment, the baseband circuitry 150 includes a decoder 160 that extracts information and parity bits from the baseband data 145. The decoder 160 decodes the baseband data 145 to obtain the information data generated by the baseband circuitry 110 of the communication system 105.

In some embodiments, each of the baseband circuitry 110 (including the encoder 130), the transmitter circuitry 120, the receiver circuitry 140, and the baseband circuitry 150 (including the decoder 160) may be as one or more processors, application specific integrated circuit (ASIC), field programmable gate array (FPGA), or any combination of them.

FIG. 2 is a schematic block diagram of a computing system, according to an embodiment. An illustrated example computing system 2000 includes one or more processors 2010 in direct or indirect communication, via a communication system 2040 (e.g., bus), with memory 2060, at least one network interface controller 2030 with network interface port for connection to a network (not shown), and other components, e.g., input/output ("I/O") components 2050. Generally, the processor(s) 2010 will execute instructions (or computer programs) received from memory. The processor(s) 2010 illustrated incorporate, or are connected to, cache memory 2020. In some instances, instructions are read from memory 2060 into cache memory 2020 and executed by the processor(s) 2010 from cache memory 2020. The computing system 2000 may not necessarily contain all of these components shown in FIG. 2, and may contain other components that are not shown in FIG. 2.

In more detail, the processor(s) 2010 may be any logic circuitry that processes instructions, e.g., instructions fetched from the memory 2060 or cache 2020. In many implementations, the processor(s) 2010 are microprocessor units or special purpose processors. The computing device 2050 may be based on any processor, or set of processors, capable of operating as described herein. The processor(s) 2010 may be single core or multi-core processor(s). The processor(s) 2010 may be multiple distinct processors.

The memory 2060 may be any device suitable for storing computer readable data. The memory 2060 may be a device with fixed storage or a device for reading removable storage media. Examples include all forms of volatile memory (e.g., RAM), non-volatile memory, media and memory devices, semiconductor memory devices (e.g., EPROM, EEPROM, SDRAM, and flash memory devices), magnetic disks, magneto optical disks, and optical discs (e.g., CD ROM, DVD-ROM, or Blu-Ray® discs). A computing system 2000 may have any number of memory devices 2060.

The cache memory 2020 is generally a form of computer memory placed in close proximity to the processor(s) 2010 for fast read times. In some implementations, the cache memory 2020 is part of, or on the same chip as, the processor(s) 2010. In some implementations, there are multiple levels of cache 2020, e.g., L2 and L3 cache layers.

The network interface controller 2030 manages data exchanges via the network interface (sometimes referred to as network interface ports). The network interface controller 2030 handles the physical and data link layers of the OSI model for network communication. In some implementations, some of the network interface controller's tasks are handled by one or more of the processor(s) 2010. In some implementations, the network interface controller 2030 is part of a processor 2010. In some implementations, the computing system 2000 has multiple network interfaces controlled by a single controller 2030. In some implementations, the computing system 2000 has multiple network interface controllers 2030. In some implementations, each network interface is a connection point for a physical network link (e.g., a cat-5 Ethernet link). In some implementations, the network interface controller 2030 supports wireless network connections and an interface port is a wireless (e.g., radio) receiver or transmitter (e.g., for any of the IEEE 802.11 protocols, near field communication "NFC", Bluetooth, ANT, or any other wireless protocol). In some implementations, the network interface controller 2030 implements one or more network protocols such as Ethernet. Generally, a computing device 2050 exchanges data with other computing devices via physical or wireless links through a network interface. The network interface may link directly to another device or to another device via an intermediary device, e.g., a network device such as a hub, a bridge, a switch, or a router, connecting the computing device 2000 to a data network such as the Internet.

The computing system 2000 may include, or provide interfaces for, one or more input or output ("I/O") devices. Input devices include, without limitation, keyboards, microphones, touch screens, foot pedals, sensors, MIDI devices, and pointing devices such as a mouse or trackball. Output devices include, without limitation, video displays, speakers, refreshable Braille terminal, lights, MIDI devices, and 2-D or 3-D printers.

Other components may include an I/O interface, external serial device ports, and any additional co-processors.

For example, a computing system 2000 may include an interface (e.g., a universal serial bus (USB) interface) for connecting input devices, output devices, or additional memory devices (e.g., portable flash drive or external media drive). In some implementations, a computing device 2000 includes an additional device such as a co-processor, e.g., a math co-processor can assist the processor 2010 with high precision or complex calculations.

The components 2090 may be configured to connect with external media, a display 2070, an input device 2080 or any other components in the computing system 2000, or combinations thereof. The display 2070 may be a liquid crystal display (LCD), an organic light emitting diode (OLED) display, a flat panel display, a solid state display, a cathode ray tube (CRT) display, a projector, a printer or other now known or later developed display device for outputting determined information. The display 2070 may act as an interface for the user to see the functioning of the processor(s) 2010, or specifically as an interface with the software stored in the memory 2060.

The input device 2080 may be configured to allow a user to interact with any of the components of the computing system 2000. The input device 2080 may be a plurality pad, a keyboard, a cursor control device, such as a mouse, or a joystick. Also, the input device 2080 may be a remote control, touchscreen display (which may be a combination of the display 2070 and the input device 2080), or any other device operative to interact with the computing system 2000, such as any device operative to act as an interface between a user and the computing system 2000.

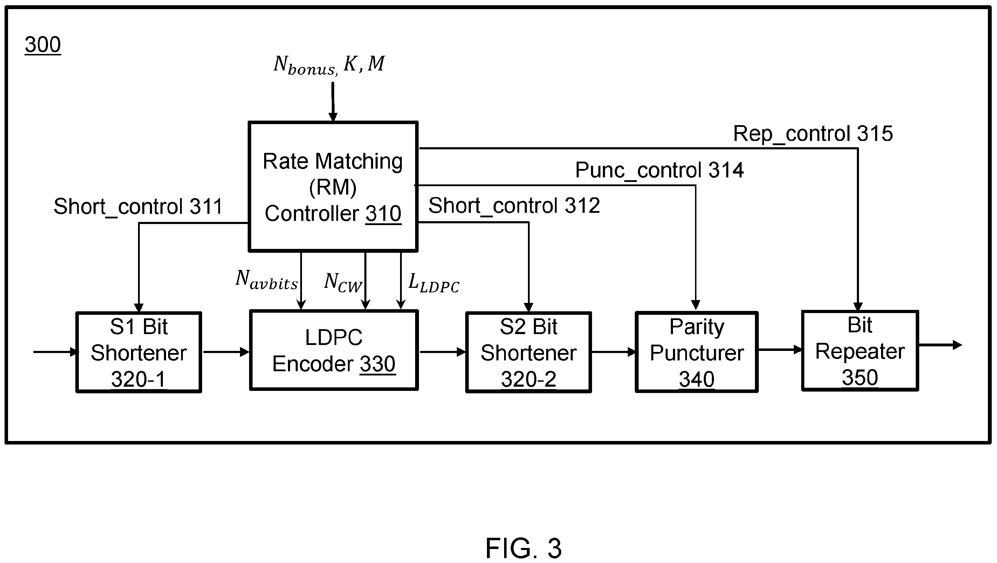

FIG. 3 is a diagram depicting an example rate matching system 300, according to one or more embodiments. The rate matching system 300 may include a rate matching (RM) controller 310, an LDPC encoder 330, a bit shortener including a stage-1 (S1) bit shortener 320-1 and a stage-2 (S2) bit shortener 320-2, a parity puncturer 340, and/or a bit repeater 350. The S1 bit shortener 320-1 may perform bit shortening addition by adding shortened bits (e.g., zeros) prior to encoding, and the S2 bit shortener 320-2 may perform bit shortening removal by removing the shortened bits (e.g., zeros). The rate matching system 300 may be included in an encoder (e.g., encoder 130) or baseband circuitry (e.g., baseband circuitry 110). The rate matching system 300 may be implemented as one or more processors, ASIC, FPGA, or any combination of them. The RM controller 310 may receive/obtain/identify/calculate at least one of $N_{bonus}$, K, or M, and calculate/compute/obtain at least one of the number of available bits $N_{avbits}$, the number of codewords $N_{CW}$, or LDPC codeword length $L_{LDPC}$ (e.g., using Equation 3 and Table 2). The RM controller then may provide the calculated $N_{avbits}$, $N_{CW}$, or $L_{LDPC}$ (as encoder parameters) to the LDPC encoder so that the LDPC encoder can encode data according to the encoder parameters.

Referring to FIG. 3, the RM controller 310 can control, based on $N_{avbits}$, $N_{CW}$, and/or $L_{LDPC}$ as calculated above, at least one of the S1 bit shortener 320-1, the S2 bit shortener 320-2, the parity puncturer 340, or the bit repeater 350. For example, the RM controller 310 can control the S1 bit shortener 320-1 and/or the S2 bit shortener 320-2 using one or more control signals (e.g., short_control 311, short_control 312) based on a value of $N_{shrt}$ calculated using Equation 4. The RM controller 310 can control the parity puncturer 340 using a control signal (e.g., punc_control 314) based on a value of $N_{punc}$ calculated using Equation 5. The RM controller 310 can control the bit repeater 350 using a control signal (e.g., rep_control 315) based on a value of $N_{rep}$ calculated using Equation 6.

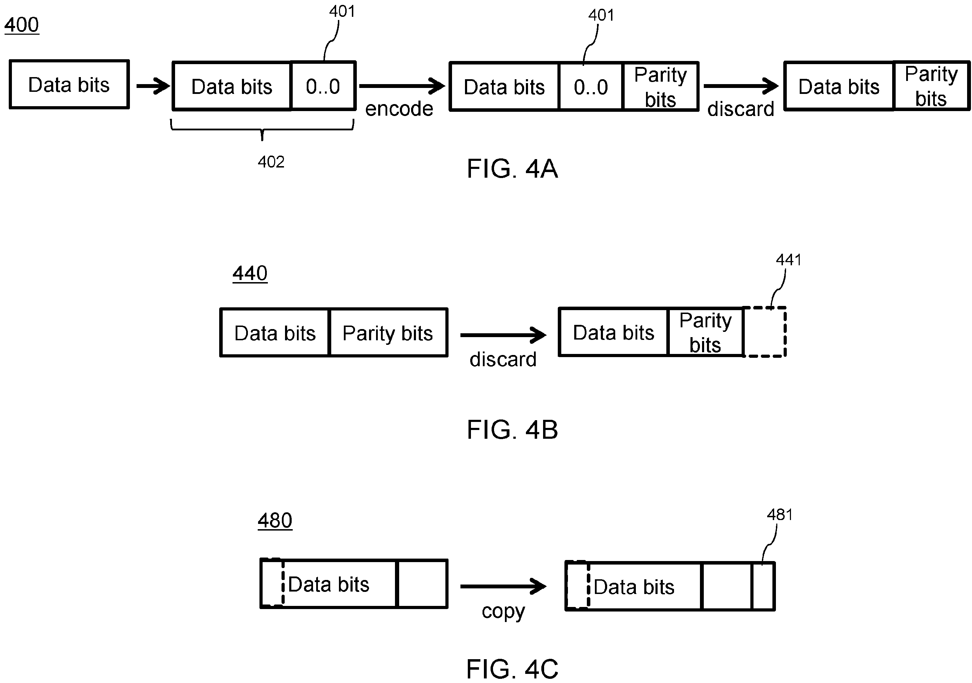

FIG. 4A, FIG. 4B, and FIG. 4C are diagrams 400, 440, 480 depicting example rate matching schemes including shortening, puncturing, and repeating, respectively, according to one or more embodiments. Referring to FIG. 4A, the bit shortener (e.g., S1 bit shortener 320-1 and S2 bit shortener 320-2) may zero pad data bits (e.g., zero padded bits or "shortened bits" 401) to match the number of systematic bits per codeword (e.g., systematic bits 402) before encoding, and discard the shortened bits 401 after encoding. In this manner, the bit shortener can reduce the effective code rate and improve a coding gain.

Referring to FIG. 4B, the parity puncturer (e.g., parity puncturer 340) may discard some parity bits (e.g., "punctured bits" 441) after encoding. In this manner, the parity puncturer 340 can increases the effective code rate and degrade a coding gain. Referring to FIG. 4C, the bit repeater (e.g., bit repeater 350) may copy some bits (e.g., "repeated bits" 481) from the start of the codeword. In this manner, the bit repeater 350 can to improves SNR.

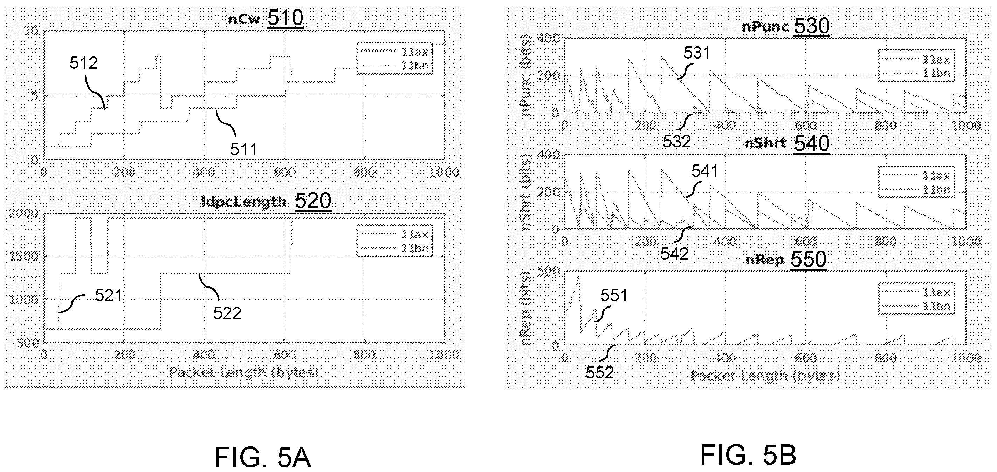

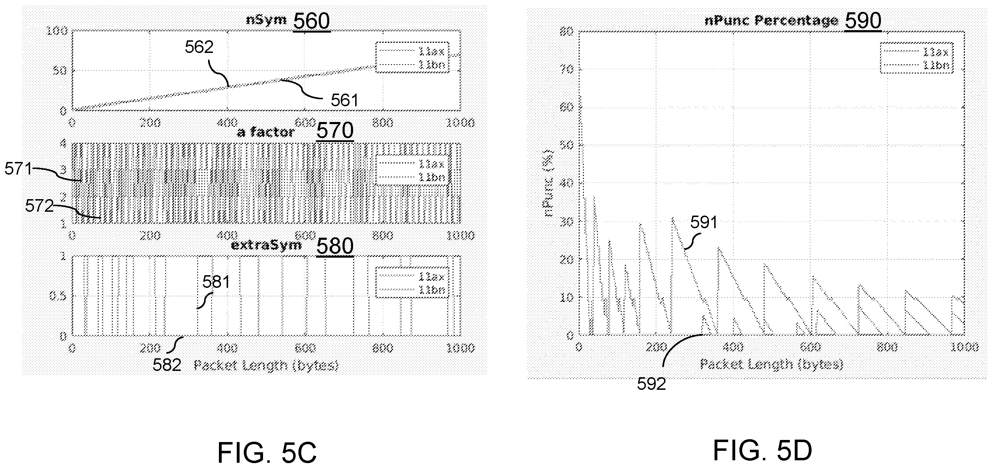

FIG. 5A, FIG. 5B, FIG. 5C, and FIG. 5D are diagrams 510, 520, 530, 540, 550, 560, 570, 580, 590 depicting example simulation results of a rate matching system, according to one or more embodiments. Simulations were performed with parameters of 20MHz BW, single-input, single output SISO (1x1) and MCS 0. A first simulation (referred to as "11ax") was performed without using $N_{bonus}$, K, M, while a second simulation (referred to as "11bn") was performed using $N_{bonus}$ = 2, K = 8 and M = 8.

The diagram 510 shows that the simulation using $N_{bonus}$, K, M (indicated by the line 512) results in higher number of codewords $N_{CW}$ than the simulation without using $N_{bonus}$, K, M (indicated by the line 511). The diagram 520 shows that the simulation using $N_{bonus}$, K, M (indicated by the line 522) results in shorter codeword length $L_{LDPC}$ than that of the simulation without using $N_{bonus}$, K, M (indicated by the line 521). The diagram 530 shows that the simulation using $N_{bonus}$, K, M (indicated by the line 532) results in fewer punctured bits $N_{punc}$ than that of the simulation without using $N_{bonus}$, K, M (indicated by the line 531). The diagram 540 shows that the simulation using $N_{bonus}$, K, M (indicated by the line 542) results in fewer shortened bits $N_{shrt}$ than that of the simulation without using $N_{bonus}$, K, M (indicated by the line 541). The diagram 550 shows that the simulation using $N_{bonus}$, K, M (indicated by the line 552) results in more repeated bits $N_{rep}$ than that of the simulation without using $N_{bonus}$, K, M (indicated by the line 551). The diagram 560 shows that the simulation using

$N_{bonus}$, $K$, $M$ (indicated by the line 562) results in more number of symbols (by two more) than that of the simulation without using $N_{bonus}$, $K$, $M$ (indicated by the line 561). The diagram 570 shows that the simulation (either that using $N_{bonus}$, $K$, $M$ (indicated by the line 572) or that without using $N_{bonus}$, $K$, $M$ (indicated by the line 571) results in the short symbol padding factor "a" ranging between 1 and 4 where 4 is a complete symbol. The diagram 580 shows that the simulation using $N_{bonus}$, $K$, $M$ (indicated by the line 582) does not result in the extra symbol indication that the puncture condition is invoked, while the simulation without using $N_{bonus}$, $K$, $M$ (indicated by the line 581) results in the extra symbol indication (e.g., 1) that the puncture condition is invoked so that the number of symbols can be increased (e.g., increased by 1). The diagram 590 shows that the simulation using $N_{bonus}$, $K$, $M$ (indicated by the line 592) results in lower parity puncture rate (e.g., less than 7%) than that of the simulation without using $N_{bonus}$, $K$, $M$ (indicated by the line 591).

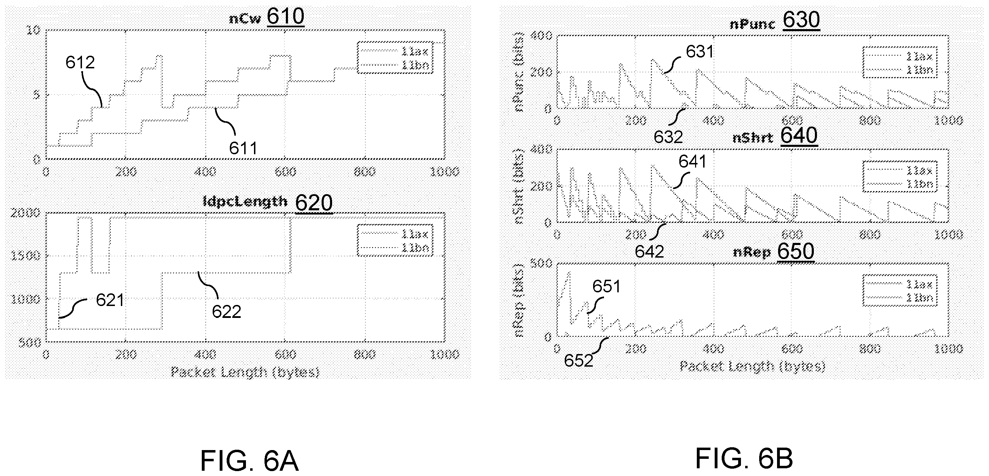

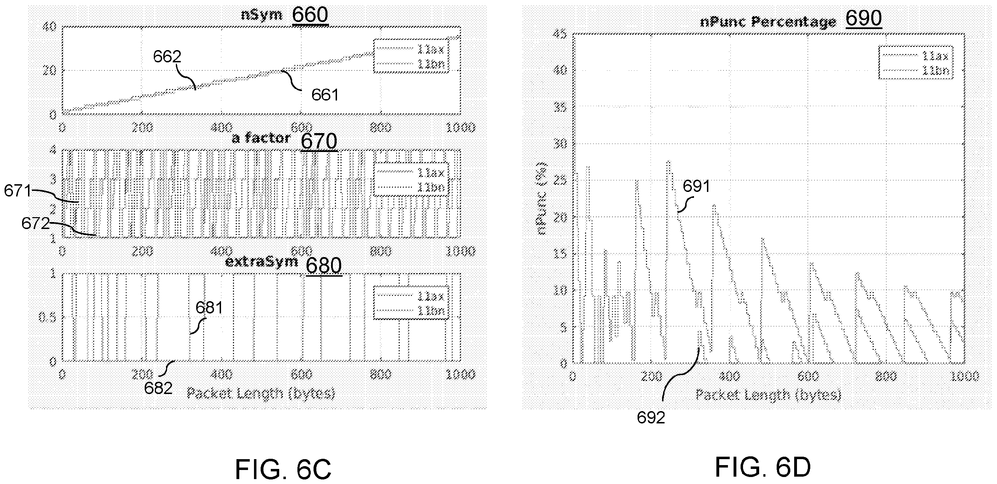

FIG. 6A, FIG. 6B, FIG. 6C, and FIG. 6D are diagrams 610, 620, 630, 640, 660, 660, 670, 680, 690 depicting example simulation results of a rate matching system, according to one or more embodiments. Simulations were performed with parameters of 20MHz BW, single-input, single output SISO (1x1) and MCS 1. A first simulation (referred to as "11ax") was performed without using $N_{bonus}$, $K$, $M$, while a second simulation (referred to as "11bn") was performed using $N_{bonus}$ = 1, $K$ = 8 and $M$ = 8.

The diagram 610 shows that the simulation using $N_{bonus}$, $K$, $M$ (indicated by the line 612) results in higher number of codewords $N_{CW}$ than the simulation without using $N_{bonus}$, $K$, $M$ (indicated by the line 611). The diagram 620 shows that the simulation using $N_{bonus}$, $K$, $M$ (indicated by the line 622) results in shorter codeword length $L_{LDPC}$ than that of the simulation without using $N_{bonus}$, $K$, $M$ (indicated by the line 621). The diagram 630 shows that the simulation using $N_{bonus}$, $K$, $M$ (indicated by the line 632) results in fewer punctured bits $N_{punc}$ than that of the simulation without using $N_{bonus}$, $K$, $M$ (indicated by the line 631). The diagram 640 shows that the simulation using $N_{bonus}$, $K$, $M$ (indicated by the line 642) results in fewer shortened bits $N_{shrt}$ than that of the simulation without using $N_{bonus}$, $K$, $M$ (indicated by the line 641). The diagram 650 shows that the simulation using $N_{bonus}$, $K$, $M$ (indicated by the line 652) results in more repeated bits $N_{rep}$ than that of the simulation without using $N_{bonus}$, $K$, $M$ (indicated by the line 651). The diagram 660 shows that the simulation using $N_{bonus}$, $K$, $M$ (indicated by the line 662) results in more number of symbols (by one more) than that of the simulation without using $N_{bonus}$, $K$, $M$ (indicated by the line 661). The diagram 670 shows that the simulation (either that using $N_{bonus}$, $K$, $M$ (indicated by the line 672) or that without using $N_{bonus}$, $K$, $M$ (indicated by the line 671) results in the short symbol padding factor "a" ranging between 1 and 4 where 4 is a complete symbol. The diagram 680 shows that the simulation using $N_{bonus}$, $K$, $M$ (indicated by the line 682) does not result in the extra symbol indication that the puncture condition is invoked, while the simulation without using $N_{bonus}$, $K$, $M$ (indicated by the line 681) results in the extra symbol indication (e.g., 1) that the puncture condition is invoked so that the number of symbols can be increased (e.g., increased by 1). The diagram 690 shows that the simulation using $N_{bonus}$, $K$, $M$ (indicated by the line 692) results in lower parity puncture rate (e.g., less than 8%) than that of the simulation without using $N_{bonus}$, $K$, $M$ (indicated by the line 691).

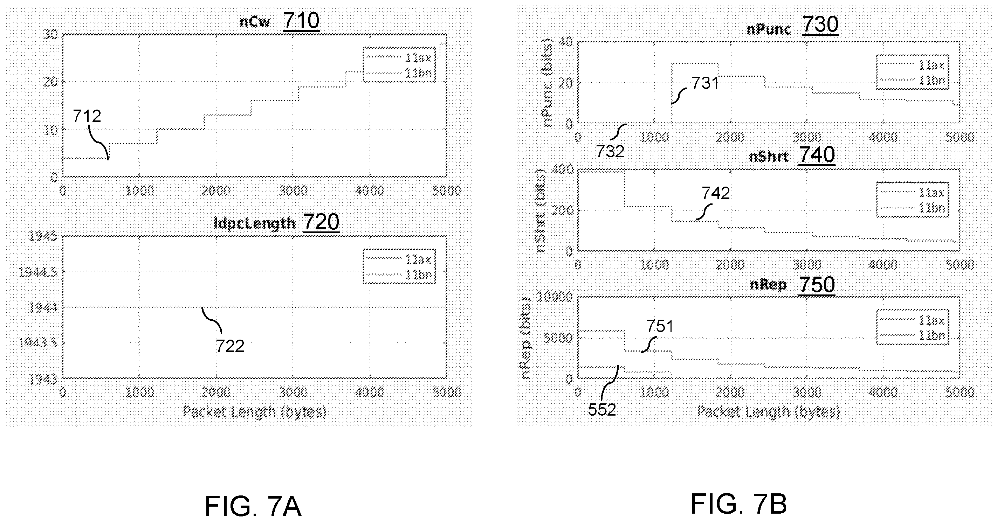

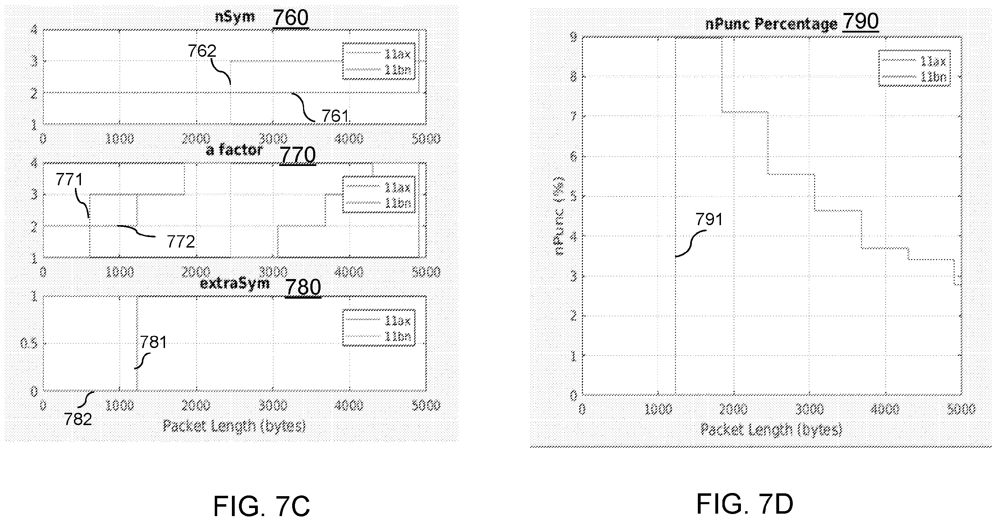

FIG. 7A, FIG. 7B, FIG. 7C, and FIG. 7D are diagrams 710, 720, 730, 740, 750, 760, 770, 780, 790 depicting example simulation results of a rate matching system, according to one or more embodiments. Simulations were performed with parameters of 160 MHz BW, MIMO (2x2) and MCS 7. A first simulation (referred to as "11ax") was performed without using $N_{bonus}$, $K$, $M$, while a second simulation (referred to as "11bn") was performed using $N_{bonus}$ = 1, $K$ = 8 and $M$ = 8.

The diagram 710 shows that the simulation using $N_{bonus}$, $K$, $M$ and the simulation without using $N_{bonus}$, $K$, $M$ (both indicated by the line 712) result in the same number of codewords $N_{CW}$. The diagram 720 shows that the simulation using $N_{bonus}$, $K$, $M$ and the simulation without using $N_{bonus}$, $K$, $M$ (both indicated by the line 722) result in the same codeword length $L_{LDPC}$. The diagram 730 shows that the simulation using $N_{bonus}$, $K$, $M$ (indicated by the line 732) results in fewer punctured bits $N_{punc}$ than that of the simulation without using $N_{bonus}$, $K$, $M$ (indicated by the line 731). The diagram 740 shows that the simulation using $N_{bonus}$, $K$, $M$ and the simulation without using $N_{bonus}$, $K$, $M$ (both indicated by the line 742) result in the same shortened bits $N_{shrt}$. The diagram 750 shows that the simulation using $N_{bonus}$, $K$, $M$ (indicated by the line 752) results in more repeated bits $N_{rep}$ than that of the simulation without using $N_{bonus}$, $K$, $M$ (indicated by the line 751). The diagram 760 shows that the simulation using $N_{bonus}$, $K$, $M$ (indicated by the line 762) results in more number of symbols (by one more) than that of the simulation without using $N_{bonus}$, $K$, $M$ (indicated by the line 761). The diagram 770 shows that the simulation (either that using $N_{bonus}$, $K$, $M$ (indicated by the line 772) or that without using $N_{bonus}$, $K$, $M$ (indicated by the line 771) results in the short symbol padding factor "a" ranging between 1 and 4 where 4 is a complete symbol. The diagram 780 shows that the simulation using $N_{bonus}$, $K$, $M$ (indicated by the line 782) does not result in the extra symbol indication that the puncture condition is invoked, while the simulation without using $N_{bonus}$, $K$, $M$ (indicated by the line 781) may result in the extra symbol indication (e.g., 1) that the puncture condition is invoked so that the number of symbols can be increased (e.g., increased by 1). The diagram 790 shows that the simulation using $N_{bonus}$, $K$, $M$ (indicated by the line 792) results in lower parity puncture rate (e.g., 0%) than that of the simulation without using $N_{bonus}$, $K$, $M$ (indicated by the line 791).

FIG. 8 shows diagrams 801, 802, 803, 804, 805 ,806, 807, 808, 809, 810, 811 depicting respective example simulation results with which to determine a minimum number of additional (bonus) symbols as a parameter of a rate matching system, according to one or more embodiments. Each diagram shows, for different ss (spatial streams) values (e.g., 1ss, 2ss, 3ss, 4ss), MCS numbers in the x-axis and the minimum numbers of bonus symbols that results in the parity puncture rate < 8%, in the y-axis. Each diagram shows a simulation result using a different number of resource units (RUs). For example, the number of RUs used for the diagrams 801, 802, 803, 804, 805 ,806, 807, 808, 809, 810, 811 are 26, 62, 106, 242 ,484, 996, 2*996, 2*996+484, 3*996, 3*996+484, 4*996, respectively. As shown in the diagrams, the minimum number of bonus symbols that results in the parity puncture rate < 8% is one (1) for all RU >= 242, with the exception of RU 242 MCS 0. Based on this result, the system can determine to set $N_{bonus}$ = 1 to result in the parity puncture rate < 8%.

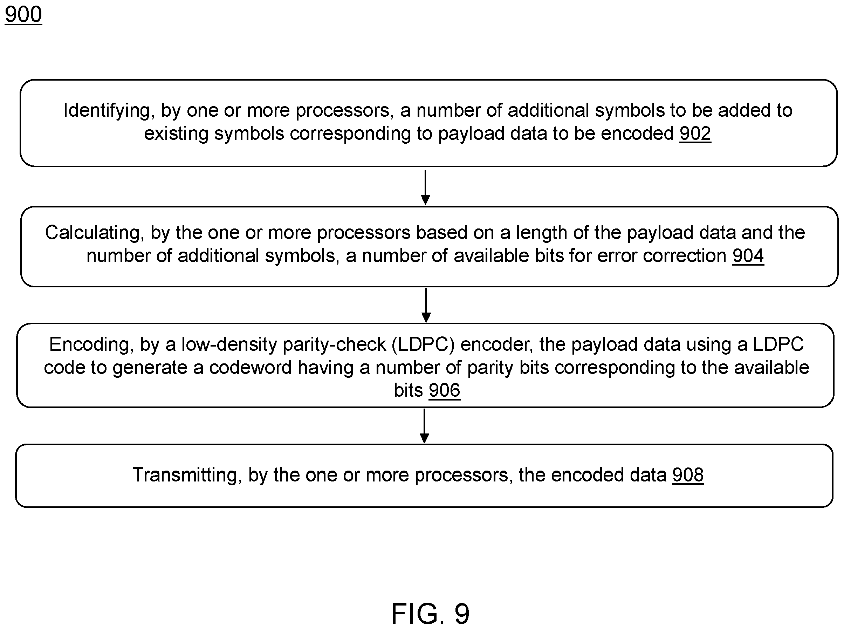

FIG. 9 is a flow diagram showing a process 900 for encoding data using a rate matching system (e.g., rate matching system 300), in accordance with an embodiment. In some implementations, the process 900 is performed by one or more processors of an apparatus (e.g., an encoder 130 or a processor 2010 of a communication system 105, 108). In other embodiments, the process 900 is performed by other entities (e.g., a computing system other than the system 105, 108). In some embodiments, the process 900 includes more, fewer, or different steps than shown in FIG. 9.

At step 902, the one or more processors may identify a number of additional symbols (e.g., $N_{bonus}$) to be added to existing symbols corresponding to payload data to be encoded. In some implementations, in identifying the number of additional symbols to be added to the existing symbols, the one or more processors may determine a number of shortened bits (e.g., $N_{shrt}$). The one or more processors may determine, based on the number of shortened bits, a number of punctured bits (e.g., $N_{punc}$ using Equation 5) and a percentage of punctured bits (e.g., parity puncture rate). In identifying the number of additional symbols to be added to the existing symbols, the one or more processors may identify the number of additional symbols (e.g., $N_{bonus}$=1) that reduces the percentage of punctured bits to a threshold percentage (e.g., 8%). The identified number of additional symbols may be a minimum number of additional bits that reduces the percentage of punctured bits to the threshold percentage. For example, FIG. 8 shows that the minimum number of additional bits that reduces the parity puncture rate less than 8% is 1.

In some implementations, in identifying the number of additional symbols to be added to the existing symbols, the one or more processors may determine the number of additional symbols based on at least one of at least one of bandwidth (e.g., BW), a number of spatial streams (e.g., NSS), or a modulation and coding scheme (e.g., MCS).

At step 904, the one or more processors may calculate, based on a length of the payload data (e.g., $N_{pld}$) and the number of additional symbols e.g., $N_{bonus}$), a number of available bits (e.g., $N_{avbits}$) for error correction (e.g., using Equation 3).

At step 906, the one or more processors may encode, by a low-density parity-check (LDPC) encoder (e.g., LDPC encoder 330), the payload data using a LDPC code to generate a codeword having a number of parity bits corresponding to the available bits (e.g., $N_{avbits}$). In some implementations, in encoding the payload data, the one or more processors may receive a plurality of information bits that contain the payload data and a set of bits having the calculated number of available bits. The one or more processors may encode the plurality of information bits to generate the codeword.

At step 908, the one or more processors may transmit the encoded data. For example, the communication system 105 may transmit the encoded data to the communication system 108.

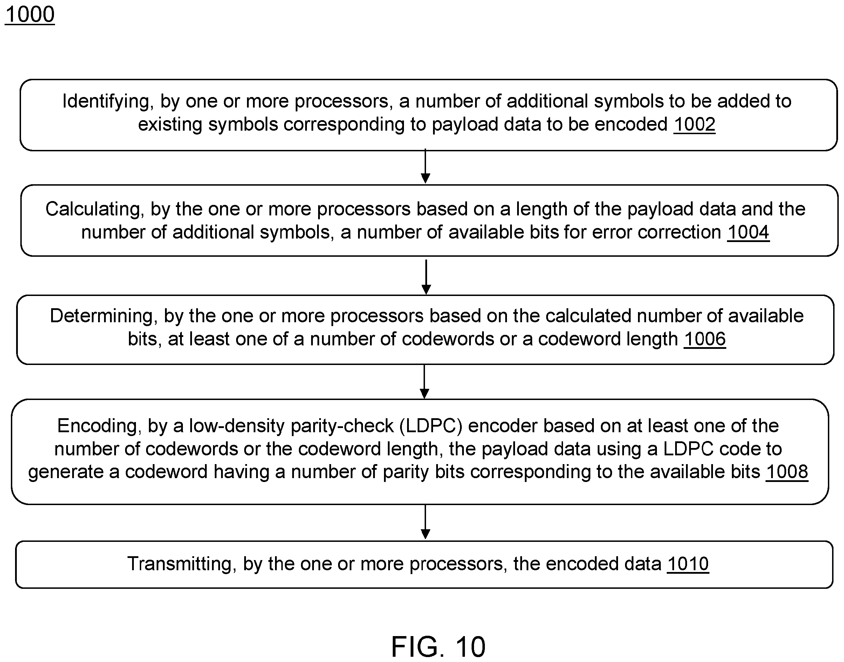

FIG. 10 is a flow diagram showing a process 1000 for encoding data using a rate matching system (e.g., rate matching system 300), in accordance with an embodiment. In some implementations, the process 1000 is performed by one or more processors of an apparatus (e.g., an encoder 130 or a processor 2010 of a communication system 105, 108). In other embodiments, the process 1000 is performed by other entities (e.g., a computing system other than the system 105 or the system 108). In some embodiments, the process 1000 includes more, fewer, or different steps than shown in FIG. 10.

At step 1002, the one or more processors may identify a number of additional symbols (e.g., $N_{bonus}$) to be added to existing symbols corresponding to payload data to be encoded. In some implementations, in identifying the number of additional symbols to be added to the existing symbols, the one or more processors may determine a number of shortened bits (e.g., $N_{shrt}$). The one or more processors may determine, based on the number of shortened bits, a number of punctured bits (e.g., $N_{punc}$ using Equation 5) and a percentage of punctured bits (e.g., parity puncture rate).

In some implementations, in identifying the number of additional symbols to be added to the existing symbols, the one or more processors may identify the number of additional symbols that reduces the percentage of punctured bits to a threshold percentage (e.g., $N_{bonus}$ that can reduce the parity puncture rate to less than 8%). The identified number of additional symbols may be a minimum number of additional bits that reduces the percentage of punctured bits to the threshold percentage. For example, FIG. 8 shows that the minimum number of additional bits that reduces the parity puncture rate less than 8% is 1.

In some implementations, in identifying the number of additional symbols to be added to the existing symbols, the one or more processors may determine the number of additional symbols based on at least one of at least one of bandwidth (e.g., BW), a number of spatial streams (e.g., NSS), or a modulation and coding scheme (e.g., MCS).

At step 1004, the one or more processors may calculate, based on a length of the payload data (e.g., $N_{pld}$) and the number of additional symbols e.g., $N_{bonus}$), a number of available bits (e.g., $N_{avbits}$) for error correction (e.g., using Equation 3).

At step 1006, the one or more processors may determine, based on the calculated number of available bits (e.g., $N_{avbits}$), at least one of a number of codewords (e.g., $N_{CW}$) or a codeword length (e.g., $L_{LDPC}$). In some implementations, in determining at least one of a number of codewords or a codeword length, the one or more processors may determine whether the calculated number of available bits is less than or equal to an integer multiple of a first value (e.g., whether $N_{avbits}$ is less than or equal to $K \cdot 648$). In response to determining that the calculated number of available bits is less than or equal to the integer multiple of the first value, the one or more processors may determine the number of codewords (e.g., $\left\lceil \frac{N_{pld}}{648 \cdot R} \right\rceil$) based on the first value and the length of the payload data and setting the codeword length to the first value (e.g., 648). In determining at least one of a number of codewords or a codeword length, the one or more processors may determine whether the calculated number of available bits is less than or equal to an integer multiple of a second value that is greater than the first value (e.g., whether $N_{avbits}$ is less than or equal to $M \cdot 1296$). In response to determining that the calculated number of available bits is less than or equal to the integer multiple of the second value, the one or more processors may determine the number of codewords (e.g., $\left\lceil \frac{N_{pld}}{1296 \cdot R} \right\rceil$) based on the second value and the length of the payload data and setting the codeword length to the second value (e.g., 1296).

At step 1008, the one or more processors may encode, by a low-density parity-check (LDPC) encoder (e.g., encoder 130 or LDPC encoder 330) based on at least one of the number of codewords (e.g., $N_{CW}$) or the codeword length (e.g., $L_{LDPC}$), the payload data using a LDPC code to generate a codeword having a number of parity bits corresponding to the available bits.

In some implementations, in encoding the payload data, the one or more processors may receive a plurality of information bits that contain the payload data and a set of bits having the calculated number of available bits. The one or more processors may encode the plurality of information bits to generate the codeword.

At step 1010, the one or more processors may transmit the encoded data. For example, the communication system 105 may transmit the encoded data to the communication system 108.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A system (105), comprising:

   a transmitter (120); and
   one or more processors (2010) configured to:

   identify a number of additional symbols to be added to existing symbols corresponding to payload data to be encoded;

calculate, based on a length of the payload data and the number of additional symbols, a number of available bits for error correction;

encode, via an low-density parity-check, LDPC, encoder (130), the payload data using an LDPC code to generate a codeword having a number of parity bits corresponding to the available bits; and

transmit, via the transmitter (120), the encoded data.

2. The system (105) of claim 1, wherein to encode the payload data, the one or more processors (2010) are configured to:

receive a plurality of information bits that contain the payload data and a set of bits having the calculated number of available bits, and

encode the plurality of information bits to generate the codeword.

3. The system (105) of claim 1 or 2, wherein to identify the number of additional symbols to be added to the existing symbols, the one or more processors (2010) are configured to:

determine a number of shortened bits; and

determine, based on the number of shortened bits, a number of punctured bits and a percentage of punctured bits.

4. The system (105) of claim 3, wherein to identify the number of additional symbols to be added to the existing symbols, the one or more processors (2010) are configured to identify the number of additional symbols that reduces the percentage of punctured bits to a threshold percentage;

in particular wherein the identified number of additional symbols is a minimum number of additional bits that reduces the percentage of punctured bits to the threshold percentage.

5. The system (105) of any of claims 1 to 4, wherein to identify the number of additional symbols to be added to the existing symbols, the one or more processors (2010) are configured to determine the number of additional symbols based on at least one of bandwidth, a number of spatial streams, or a modulation and coding scheme.

6. A method, comprising:

identifying, by one or more processors (2010), a number of additional symbols to be added to existing symbols corresponding to payload data to be encoded;

calculating, by the one or more processors (2010) based on a length of the payload data and the number of additional symbols, a number of available bits for error correction;

encoding, by a low-density parity-check, LDPC, encoder (130), the payload data using a LDPC code to generate a codeword having a number of parity bits corresponding to the available bits; and

transmitting, by the one or more processors (2010), the encoded data.

7. The method of claim 6, wherein encoding the payload data comprises:

receiving a plurality of information bits that contain the payload data and a set of bits having the calculated number of available bits, and

encoding the plurality of information bits to generate the codeword.

8. The method of claim 6 or 7, wherein identifying the number of additional symbols to be added to the existing symbols comprises:

determining a number of shortened bits; and

determining, based on the number of shortened bits, a number of punctured bits and a percentage of punctured bits;

in particular wherein identifying the number of additional symbols to be added to the existing symbols comprises identifying the number of additional symbols that reduces the percentage of punctured bits to a threshold percentage;

in particular wherein the identified number of additional symbols is a minimum number of additional bits that reduces the percentage of punctured bits to the threshold percentage.

9. The method of any of claims 6 to 8, wherein identifying the number of additional symbols to be added to the existing symbols comprises determining the number of additional symbols based on at least one of at least one of bandwidth, a number of spatial streams, or a modulation and coding scheme.

10. A method, comprising:

identifying, by one or more processors (2010), a number of additional symbols to be added to existing symbols corresponding to payload data to be encoded;
calculating, by the one or more processors (2010) based on a length of the payload data and the number of additional symbols, a number of available bits for error correction;
determining, by the one or more processors (2010) based on the calculated number of available bits, at least one of a number of codewords or a codeword length.
encoding, by a low-density parity-check, LDPC, encoder (130) based on at least one of the number of codewords or the codeword length, the payload data using a LDPC code to generate a codeword having a number of parity bits corresponding to the available bits; and
transmitting, by the one or more processors (2010), the encoded data.

11. The method of claim 10, wherein encoding the payload data comprises:

receiving a plurality of information bits that contain the payload data and a set of bits having the calculated number of available bits, and
encoding the plurality of information bits to generate the codeword.

12. The method of claim 10 or 11, wherein identifying the number of additional symbols to be added to the existing symbols comprises:

determining a number of shortened bits; and
determining, based on the number of shortened bits, a number of punctured bits and a percentage of punctured bits.

13. The method of claim 12, wherein identifying the number of additional symbols to be added to the existing symbols comprises identifying the number of additional symbols that reduces the percentage of punctured bits to a threshold percentage;
in particular wherein the identified number of additional symbols is a minimum number of additional bits that reduces the percentage of punctured bits to the threshold percentage.

14. The method of any of claims 10 to 13, wherein identifying the number of additional symbols to be added to the existing symbols comprises determining the number of additional symbols based on at least one of at least one of bandwidth, a number of spatial streams, or a modulation and coding scheme.

15. The method of any of claims 10 to 14, wherein determining at least one of a number of codewords or a codeword length comprises:

determining whether the calculated number of available bits is less than or equal to an integer multiple of a first value; and
in response to determining that the calculated number of available bits is less than or equal to the integer multiple of the first value, determining the number of codewords based on the first value and the length of the payload data and setting the codeword length to the first value;

in particular wherein determining at least one of a number of codewords or a codeword length further comprises:

determining whether the calculated number of available bits is less than or equal to an integer multiple of a second value that is greater than the first value; and
in response to determining that the calculated number of available bits is less than or equal to the integer multiple of the second value, determining the number of codewords based on the second value and the length of the payload data and setting the codeword length to the second value.

FIG. 1

EP 4 586 503 A1

**Computing system 2000**

Cache 2020 ↔ Processor 2010

I/O Components 2050

Display 2070

Input Device 2080

Communication System 2040

Memory 2060

Network Interface Device 2030

EP 4 586 503 A1

FIG. 2

FIG. 3

FIG. 4A

FIG. 4B

FIG. 4C

FIG. 5A

FIG. 5B

FIG. 5C

FIG. 5D

EP 4 586 503 A1

FIG. 6A

FIG. 6B

FIG. 6C

FIG. 6D

FIG. 7A

FIG. 7B

EP 4 586 503 A1

**nPunc Percentage 790**

nPunc (%)

Packet Length (bytes)

791

Legend: 11ax, 11bn

FIG. 7D

**nSym 760**

761

762

**a factor 770**

771

772

**extraSym 780**

781

782

Packet Length (bytes)

Legend: 11ax, 11bn

FIG. 7C

23

FIG. 8

EP 4 586 503 A1

900

Identifying, by one or more processors, a number of additional symbols to be added to existing symbols corresponding to payload data to be encoded 902

Calculating, by the one or more processors based on a length of the payload data and the number of additional symbols, a number of available bits for error correction 904

Encoding, by a low-density parity-check (LDPC) encoder, the payload data using a LDPC code to generate a codeword having a number of parity bits corresponding to the available bits 906

Transmitting, by the one or more processors, the encoded data 908

FIG. 9

```
┌─────────────────────────────────────────────────────────────────────────────┐
│ Identifying, by one or more processors, a number of additional symbols to be  │
│ added to existing symbols corresponding to payload data to be encoded 1002    │
└─────────────────────────────────────────────────────────────────────────────┘
                                      │
                                      ▼
┌─────────────────────────────────────────────────────────────────────────────┐
│ Calculating, by the one or more processors based on a length of the payload   │
│ data and the number of additional symbols, a number of available bits for     │
│ error correction 1004                                                         │
└─────────────────────────────────────────────────────────────────────────────┘
                                      │
                                      ▼
┌─────────────────────────────────────────────────────────────────────────────┐
│ Determining, by the one or more processors based on the calculated number of  │
│ available bits, at least one of a number of codewords or a codeword length    │
│ 1006                                                                          │
└─────────────────────────────────────────────────────────────────────────────┘
                                      │
                                      ▼
┌─────────────────────────────────────────────────────────────────────────────┐
│ Encoding, by a low-density parity-check (LDPC) encoder based on at least one   │
│ of the number of codewords or the codeword length, the payload data using a    │
│ LDPC code to generate a codeword having a number of parity bits corresponding  │
│ to the available bits 1008                                                     │
└─────────────────────────────────────────────────────────────────────────────┘
                                      │
                                      ▼
┌─────────────────────────────────────────────────────────────────────────────┐
│ Transmitting, by the one or more processors, the encoded data 1010            │
└─────────────────────────────────────────────────────────────────────────────┘
```

FIG. 10

Europäisches Patentamt

European Patent Office

Office européen des brevets

# EUROPEAN SEARCH REPORT

**Application Number**

EP 25 15 0707

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/227437 A1 (BLANKSBY ANDREW [US] ET AL) 4 August 2016 (2016-08-04) * the whole document * | 1-15 | INV. H03M13/11 H03M13/00 H04L1/00 |
| X | WO 2023/040668 A1 (HUAWEI TECH CO LTD [CN]) 23 March 2023 (2023-03-23) * the whole document * & EP 4 391 390 A1 (HUAWEI TECH CO LTD [CN]) 26 June 2024 (2024-06-26) * the whole document * | 1-15 | |
| A | US 2021/194623 A1 (HU SHENGQUAN [US] ET AL) 24 June 2021 (2021-06-24) * the whole document * | 1-15 | |
| A | "IEEE Standard for Information Technology--Telecommunications and Information Exchange between Systems Local and Metropolitan Area Networks--Specific Requirements Part 11: Wireless LAN Medium Access Control (MAC) and Physical Layer (PHY) Specifications Amendment 2: Enhanced Throughput for Operation i", IEEE STANDARD, IEEE, PISCATAWAY, NJ USA , 28 July 2021 (2021-07-28), pages 1-768, XP068184357, DOI: 10.1109/IEEESTD.2021.9502046 ISBN: 978-1-5044-7506-8 Retrieved from the Internet: URL:https://ieeexplore.ieee.org/document/9502046 [retrieved on 2021-07-30] * the whole document * | 1-15 | TECHNICAL FIELDS SEARCHED (IPC) H03M H04L |

The present search report has been drawn up for all claims

| Place of search | Date of completion of the search | Examiner |
|---|---|---|
| Munich | 24 April 2025 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 25 15 0707

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2025

| Patent document cited in search report | Publication date | Patent family member(s) | Publication date |
|---|---|---|---|
| US 2016227437 A1 | 04-08-2016 | DE 102016001166 A1 | 04-08-2016 |
| | | DE 102016007395 A1 | 17-11-2016 |
| | | US 2016227437 A1 | 04-08-2016 |
| | | US 2018123832 A1 | 03-05-2018 |
| | | US 2019116062 A1 | 18-04-2019 |
| WO 2023040668 A1 | 23-03-2023 | CN 115811379 A | 17-03-2023 |
| | | EP 4391390 A1 | 26-06-2024 |
| | | TW 202315342 A | 01-04-2023 |
| | | US 2024235729 A1 | 11-07-2024 |
| | | WO 2023040668 A1 | 23-03-2023 |
| US 2021194623 A1 | 24-06-2021 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63619958

**Non-patent literature cited in the description**

- **RICHARDSON** ; **URBANKE**. *IEEE Transactions on Information Theory*, February 2001, vol. 47 (2)